# EUROPÄISCHE PATENTSCHRIFT

(11) **EP 1 573 242 B1**
(45) Veröffentlichungstag und Bekanntmachung des Hinweises auf die Patenterteilung: **10.05.2006**
(21) Anmeldenummer: 03799591.7
(22) Anmeldetag: 18.12.2003
(51) Int. Cl.: F16K 27/00, F15B 13/00

(54) **KOMPAKTES ELEKTROPNEUMATISCHES MEHRWEGEVENTIL MIT PLATZSPAREND UNTERGEBRACHTER VENTILANSTEUERUNG**
COMPACT ELECTROPNEUMATIC MULTIPATH VALVE COMPRISING A COMPACT VALVE CONTROL
DISTRIBUTEUR MULTIVOIE ELECTROPNEUMATIQUE COMPACT COMPORTANT UN ORGANE DE COMMANDE DE SOUPAPE PEU ENCOMBRANT

(30) Priorität: 20.12.2002 DE 10260139
(43) Veröffentlichungstag der Anmeldung: 14.09.2005
(73) Patentinhaber: Rexroth Mecman GmbH, 30880 Laatzen (DE)
(72) Erfinder: FORTMANN, Norbert, 30163 Hannover (DE); JANETZ, Ulrich, 30451 Hannover (DE); BRANDES, Wolfgang, 30419 Hannover (DE); KREBS, Herbert, 30823 Garbsen (DE); LIESENHOFF, Thomas, 30159 Hannover (DE); MEYER, Ernst-August, 30974 Wenningsen (DE)
(74) Vertreter: Kietzmann, Lutz
(86) Internationale Anmeldenummer: PCT/EP2003/051074
(87) Internationale Veröffentlichungsnummer: WO 2004/057220

(56) Entgegenhaltungen:
- EP-A- 1 094 228
- DE-A- 19 519 414
- DE-U- 29 522 027
- US-A- 5 277 622

## Beschreibung

Die Erfindung betrifft ein kompaktes elektropneumatisches Mehrwegeventil zum Schalten eines Druckmittelflusses mit einem eine Ventilmechanik enthaltenden Ventilkörper, der einander gegenüberliegende Seitenflächen für die Aneinanderreihung gleichartiger Ventilkörper zur Bildung einer Ventileinheit und an zumindest einer der gegenüberliegenden Seitenflächen von außen her zugängliche Hohlräume aufweist, sowie eine Ventilansteuerung, umfassend eine den Hohlräumen zugeordnete Leiterplatte mit darauf angeordneten elektronischen Bauelementen zur Ansteuerung der Ventilmechanik.

Ein Mehrwegeventil mit den im Oberbegriff von Anspruch 1 definierten Merkmalen ist aus der EP-A-1 094 228 bekannt.

Weitere Mehrwegeventile sind beispielsweise aus dem Rexroth-Katalog "Know-how in Pneumatics", Drucknummer 00010 006 01, Druckdatum 1998-09-01, Elanders Tofters, Östervala 1998 01961 bekannt, bei denen die Ventilgehäuse zur Bildung einer Ventileinheit aneinanderreihbar sind.

Die Mehrwegeventile bestehen im Prinzip aus einem Ventilkörper, in welchem eine Ventilmechanik zum Schalten des den Ventilkörper durchströmenden Druckmittelflusses untergebracht ist und einer Ventilansteuerung. Die Ventilmechanik kann beispielsweise aus einem herkömmlichen Ventilschieber bestehen, welcher druckmittelvermittelnd zwischen einem Speisedruckanschluss sowie einem Entlüftungsanschluss einerseits, sowie mindestens einem Arbeitsanschluss andererseits nach Art eines 3/2-Wege-Ventils oder einer anderen Ventilfunktion schaltet.

Der Arbeitsanschluss steht über eine weiterführende Verbindungsrohrleitung mit einem Druckmittelaggregat - beispielsweise einem Pneumatikzylinder - in Verbindung, um die Beaufschlagung mit Druckmittel zu steuern. Zu diesem Zwecke ist die Ventilmechanik des Mehrwegeventils über ein Pilotventil mit einem Steuerdruck oder direkt über einen Elektromagneten betätigbar. Elektrische Ansteuersignale gelangen von einer Ventilansteuerung mittels eines Datenbusses oder über eine konventionelle Verdrahtung an das Pilotventil bzw. den Elektromagneten des Mehrwegeventils. Die Ventilansteuerung, Ventilkörper-und Ventilmechanik bilden dabei jedes für sich ein eigenes Modul. Die Verbindung ist dabei meist stapelartig realisiert, das bedeutet, dass die Module aneinandergereiht sind. Das Mehrwegeventil benötigt allerdings zur Unterbringung der Ventilansteuerung - insbesondere der elektronischen Bauelemente - einen relativ großen Bauraum.

In jüngster Zeit geht der technische Trend bei Mehrwegeventilen jedoch vermehrt in Richtung einer möglichst kompakten Bauform. Insbesondere da Mehrwegeventile meist in andere Anlagen integriert werden, steht die Miniaturisierung der Mehrwegeventile im Vordergrund.

Es ist daher die Aufgabe der vorliegenden Erfindung ein Mehrwegeventil der vorstehend beschriebenen Art dahingehend weiter zu verbessern, dass eine kompakte Bauform durch optimale Ausnutzung und Gestaltung des für die Ventilansteuerung benötigten Bauraums erzielt wird.

Diese Aufgabe wird ausgehend von einem Mehrwegeventil gemäß dem Oberbegriff des Anspruchs 1 in Verbindung mit dessen kennzeichnenden Merkmalen gelöst. Vorteilhafte Weiterbildungen der Erfindung sind in den abhängigen Ansprüchen angegeben.

Die Erfindung schließt die technische Lehre ein, dass die elektronischen Bauelemente bei Montage der Leiterplatte auf der Seitenfläche des Ventilkörper von dort ausgehend zumindest teilweise in die Hohlräume hineinragen.

Diese Lösung bietet den Vorteil, dass bislang ungenutzten Hohlräume an einer definierten Fläche des Ventilkörpers beim Zusammenfügen von Ventilansteuerung und Ventilkörper durch die ansonsten unnötig Bauraum belegenden Bauelemente der Ventilansteuerung genutzt wird oder Hohlräume hierfür geschaffen werden, wodurch das Mehrwegeventil insgesamt kleiner als vergleichbare Ventile baut, was darüberhinaus auch Material zur Herstellung des Ventilkörpers einspart.

Vergleichbare Mehrwegeventile benötigen aufgrund der Anordnung der Ansteucrelektronik oder Ansteuervorrichtung einen großen Bauraum oder ein großes Bauvolumen, wodurch ein Einbau in andere, Mehrwegeventile umschließende Anlagen oft nur über Adapter oder andere Verbindungskonstruktionen möglich ist.

Die erfindungsgemäße Lösung erlaubt es das Bauvolumen des Mehrwegeventils, das durch die äußere Umhüllung des Mehrwegeventils bestimmt ist, um mehr als 15 % gegenüber anderen Bauvolumina vergleichbarer Ventile zu reduzieren. Unter einer äußeren Umhüllung des Mehrwegeventils versteht man eine ein Volumen einschließende Hülle, die gleichsam wie eine Verpackung das gesamte Mehrwegeventil umhüllt oder umgibt. Das durch diese Umrandung oder auch Einhüllende definierte Volumen ist bei der vorliegenden Erfindung deutlich geringer als das Volumen vergleichbarer anderer Ventile. Dabei sind vergleichbare andere Ventile solche, die im Wesentlichen mit den sonstigen technischen Eigenschaften - abgesehen von dem Bauvolumen - wie Anzahl der Ventile und entsprechende Input- und Outputgrößen übereinstimmen. Vorzugsweise weist das Mehrwegeventil im montiertem Zustand ein Bauvolumen von < 40.000 mm³ auf.

Je schmaler ein Mehrwegeventil ausgebildet ist, desto mehr Mehrwegeventile lassen sich in einen begrenzten Bauraum einer vorhandenen Anlage einbauen. Aus diesem Grund ist es vorteilhaft, dass das im wesentlichen quaderförmige Mehrwegeventil eine Ventilbreite in montiertem Zustand aufweist, die in einem Bereich von 0 bis 15 mm liegt.

Damit das Bauvolumen so gering wie möglich ist, bietet sich die Möglichkeit, die Ventilansteuerung in den Ventilkörper zu integrieren. Um ein optimale Integration der Ventilansteuerung in den Ventilkörper zu ermöglichen, ist es vorteilhaft, dass die Wandstärken des Ventilkörpers in ihren Abmaßen derart reduziert sind, dass durch diese dünnere Ausgestaltung größere Hohlräume innerhalb des Ventilkörpers entstehen und sich auf diese Weise zusätzlich größere und/oder mehrere elektronische Bauelemente der Ventilansteuerung in dem Ventilgehäuse integrieren lassen. Unter Wandstärken des Ventilkörpers sind neben Rippen und Stege jegliche Wandungen des Ventilkörpers zu verstehen. Die Wandstärken sind dabei in dem Maße reduziert, dass sie eine sicher Funktion der Ventileinheit weiterhin gewähren und insbesondere Stabilität des gesamten Mehrwegeventil nicht wesentlich beschränken. Insbesondere ist die Wandstärke an nicht tragenden Wandungen deutlich reduziert bzw. ist die Wandung an redundanten Bereichen gänzlich entfernt.

Eine weitere die Erfindung verbessernde Maßnahme sieht vor, dass aufgrund der Integration der Ventilansteuerung in den Ventilkörper weniger und/oder kürzere elektrische Leitungen einsetzbar sind und so zusätzlicher Bauraum für Elemente des Mehrwegeventils zur Verfügung steht. Gegenüber marktüblichen Mehrwegeventilen, bei denen die Ventilansteuerung oft nur über großbauende Kontaktbrücken an dem Ventilkörper verbindbar sind, wodurch zusätzliche oder lange Leitungen notwendig sind, lässt sich erfindungsgemäß die Ventilansteuerung komplett in dem Ventilkörper integrieren, wodurch längere Leitungswege sowie zusätzliche Brücken entfallen können.

Um eine optimale Integration von Ventilansteuerung in den Ventilkörper-auch Ventilgehäuse genannt - zu ermöglichen ist eine entsprechende Ausbildung des Ventilkörpers notwendig. Besonders vorteilhaft ist es, dass die Leiterplatte aus einem flexiblen Material hergestellt ist, so dass die Leiterplatte mit den auf der Leiterplatte angeordneten elektronischen Bauelementen bei Integration flexibel an den Ventilkörper angepasst werden kann, um Bauelementen eine andere Ausrichtung zu geben oder um einfach nur eventuelle Toleranzen auszugleichen.

Besonders vorteilhaft ist es deshalb, dass das kompakte Mehrwegeventil im Wesentlichen aus Kunststoff hergestellt ist, um ein leichtbauendes Mehrwegeventil zu realisieren. Als Werkstoff bietet sich hierfür Kunststoff an, da dieser Werkstoff optimale Gestaltungsmöglichkeiten bietet und neben der hervorragenden Gestaltungsmöglichkeiten auch optimal zur Gewichtsreduzierung verwendbar ist. Prinzipiell ist jeder Kunststoff zur Herstellung des Mehrwegeventils verwendbar. Jedoch sind auch andere Werkstoffe denkbar, die sich gerade auch für den Leichtbau anbieten. Sollten aufgrund der Stabilitätsanforderungen jedoch keine der vorstehend aufgeführten Werkstoffe einsetzbar sein, ist es auch denkbar, insbesondere den Ventilkörper mittels Verbundbauweise auszuführen.

Aufgrund der kompakten Bauweise des erfindungsgemäßen Mehrwegeventils ist dieses so ausgelegt, dass es direkt in Ventile umfassende Anlagen einbaubar ist. Dazu sind die notwendigen Schnittstellen entsprechend an dem Ventilkörper auszugestalten. Insbesondere die Druckmittelanschlüsse sowie die elektrischen Leitungen müssen entsprechend ausgebildet sein. Vorzugsweise ist die Schnittstelle deshalb als Steckverbindung ausgebildet, bei der durch einen einfachen Mechanismus eine schnelle und sichere Verbindung realisiert werden kann.

Zudem ist es von Vorteil, dass die Leiterplatte benachbart zu einer der größten Seiten des im Wesentlichen quaderförmigen elektropneumatischen Mehrwegeventils angeordnet ist, wobei die Lötseite der Leiterplatte weg von dem Ventilkörper zeigt. Durch die Anordnung der Leiterplatte an der größten Seite des Ventilkörpers lässt sich die Leiterplatte mit den auf der Leiterplatte befindlichen elektronischen Bauelementen aufgrund des größeren Raumangebots optimal in dem Ventilkörper integrieren. Dadurch dass die Lötseite der Leiterplatine nach außen zeigt, lassen sich eventuelle Fehler in der Lötung nachträglich ohne Demontage der Leiterplatte aus dem Ventilkörper beheben oder ausbessern. Jedoch ist es auch denkbar, dass die Leiterplatte beidseitig mit Bauelementen bestückt ist, wobei die Leiterplatte nicht nur ein einzelnes Mehrwegeventil ansteuert, sondern gleichzeitig so ausgelegt ist, dass über die auf beiden Seiten der Leiterplatte angeordneten Bauelemente ein zweites, benachbart zum ersten Mehrwegeventil angeordnetes Mehrwegeventil angesteuert werden kann.

Bei einseitig bestückten Leiterplatten ist es vorteilhaft, dass die Leiterplatte mit der nach außen weisenden Lötseite einen Deckel für den Ventilkörper bildet, der bündig mit dem Ventilkörper abschließt. So gibt es keine aus dem Ventilkörper herausragende Bauteile oder Bauelemente, wodurch ein zusätzlicher Schutz vor Beschädigungen gegeben ist. Zudem ist diese kompakte Bauweise leichter in andere Anlagen einsetzbar. Weiterhin ermöglicht dieser bündige Abschluss mit einer Leiterplatte als Deckel eine einfache Aneinanderreihung mehrerer Mehrwegeventile zu einer Ventileinheit bestehend aus mehreren Mehrwegeventilen.

Die Ventile können dabei verschieden ausgebildet sein. Eine bevorzugte Ausführungsform sieht vor, dass die Ventilansteuerung Pilotventile umfasst, um die Ventilmechanik mit einem Steuerdruck zu beaufschlagen. Eine weitere Ausführungsform sieht vor, dass die Ventilansteuerung Elektromagneten umfasst, um die Ventilmechanik direkt anzutreiben.

Je nach Einsatzgebiet sind somit verschiedene erfindungsgemäße Ausführungsformen für unterschiedliche Zwecke einsetzbar.

Der Anschluss des Mehrwegeventils mit dem Druckmittel erfolgt in einer erfindungsgemäßen Ausführungsform über eine Grundplatte. Vorteilhaft daran ist, dass die an dem Ventilkörper angeordnete Grundplatte zur Speisedruckversorgung und Entlüftung des Pilotventils oder der Pilotventile des kompakten elektropneumatischen Mehrwegeventils ausgebildet ist.

Erfindungsgemäß lassen sich mehrere Mehrwegeventile durch Aneinanderreihung zu einer kompakten Ventileinheit anordnen. Eine erfindungsgemäße Ventileinheit besteht aus einer Vielzahl von erfindungsgemäßen Mehrwegeventilen, wobei mindestens zwei kompakte elektropneumatische Mehrwegeventile durch Aneinanderreihung zueinander über deren großflächigen Seitenflächen angeordnet sind. Dies bietet den Vorteil, dass sich auf diese Weise leistungsfähige und multifunktionale Ventileinheiten herstellen lassen, die für die verschiedensten Einsatzgebiete Verwendung finden. Aufgrund der modularen Bauweise lassen sich so für nahezu jeden Zweck kompakte Lösungen herstellen.

Vorzugsweise weist mindestens eines der aneinandergereihten Mehrwegeventile eine Leiterplatte auf, auf der die gesamte Elektronik für eine serielle Ansteuerung via Datenbus untergebracht ist. Diese Leiterplatte kann an einem Ende der Ventileinheit als Abschlussdeckel oder auch zwischen zwei benachbarten Mehrwegeventilen platziert sein.

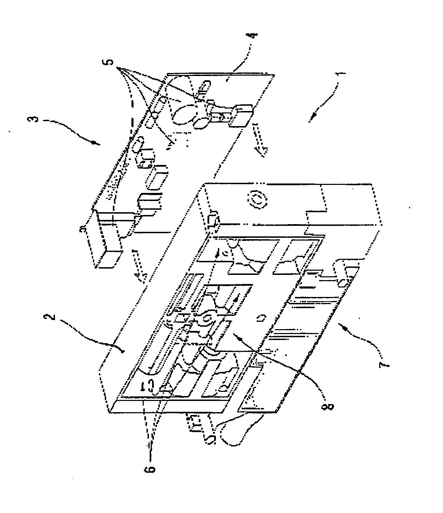

Weitere die Erfindung verbessernde Maßnahmen sind in den Unteransprüchen angegeben oder werden nachstehend gemeinsam mit der Beschreibung eines bevorzugten Ausführungsbeispiels der Erfindung anhand der einzigen Figur näher dargestellt. Die Figur zeigt eine perspektivische Explosionsdarstellung eines Ventilkörpers mit einer Ventilansteuerung.

Ein elektropneumatisches Mehrwegeventil 1 besteht aus einem eine Ventilmechanik umfassenden Ventilkörper 2 und einer Ventilansteuerung 3. Die Ventilansteuerung 3 umfasst eine Leiterplatte 4, auf der elektronische Bauelemente 5 angeordnet und untereinander verlötet sind. Die Leiterplatte 4 ist im Wesentlichen als rechteckige, dünne Platte ausgebildet, wobei das Plattenmaterial aus einem Kunststoff hergestellt ist, der trotz seiner Stabilität eine gewisse Elastizität aufweist, so dass die Platte in Grenzen elastisch biegbar ist. Auf der Leiterplatte 4 sind an verschiedenen Stellen elektrische und/oder elektronische Bauelemente 5 angeordnet, die über entsprechende Lötbahnen, die sich auf der Rückseite der Leiterplatte 4 befinden und nicht dargestellt sind, miteinander verbunden sind. Die elektronischen Bauelemente 5 sind unterschiedlicher Art und weisen zudem unterschiedliche Geometrien beziehungsweise Formen auf. Mögliche Bauelemente sind Kondensatoren, Mikroprozessoren oder ähnliche Standart-Elektronikbauteile. Mögliche Formen der Elektronikbauteile oder auch der Elektronikkomponenten sind zylindrische Formen oder quaderartige Formen sowie Kombinationen aus beiden, wobei aber auch andere Formen möglich sind. Die zur Ansteuerung des Mehrwegeventils 2 benötigten elektronischen und/oder elektrischen Bauelemente 5 der Ansteuervorrichtung 3 bedecken nicht die gesamte Oberfläche der Leiterplatte, so dass hinsichtlich der Anordnung der elektronischen oder elektrischen Bauelemente 5 ein gewisser Freiheitsgrad besteht. Durch diesen Freiheitsgrad lassen sich die elektronischen Bauteile so auf der Leiterplatte 4 anordnen, dass die gesamte Ansteuervorrichtung 3 sich in den Ventilkörper 2 integrieren lässt. Der Ventilkörper 2 weist dabei an beiden Seitenflächen 8 verschiedene Hohlräume 6 oder auch Kavitäten auf. Diese dienen zum einen der Aufnahme der in dem Ventilkörper 2 angeordneten Ventilmechanik. Zum anderen dienen die Hohlräume 6 zur Aufnahme der elektronischen oder elektrischen Bauelemente. Weiterhin weist der Ventilkörper 2 eine Grundplatte 7 auf, die zur Versorgung des Mehrwegeventils 1 mit einem Druckmittel ausgebildet ist. Die Grundplatte 7 befindet sich an einer zu den Seitenflächen 8 angrenzenden Schmalseite des Ventilkörpers 2 und ist dort so angeordnet, dass sie bündig mit dem Ventilkörper 2 abschließt.

Das gesamte Mehrwegeventil 1 weist somit im Wesentlichen keine hervorstehenden Kanten auf und bildet eine in sich geschlossene Einheit. Mehrere dieser Mehrwegeventile 1 lassen sich so auf einfache Weise über ihre Seitenflächen 8 aneinanderreihen und bilden so eine kompakte Ventileinheit.

### Bezugszeichenliste

- **1**: elektropneumatisches Mehrwegeventil
- 2: Ventilkörper
- 3: Ventilansteuerung
- 4: Leiterplatte
- 5: Bauelemente (elektronische)
- **6**: Hohlräume
- 7: Grundplatte
- **8**: Seitenfläche (exemplarisch)

## Patentansprüche

1. Kompaktes elektropneumatisches Mehrwegeventil (1) zum Schalten eines Druckmittelflusses mit einem eine Ventilmechanik enthaltenden Ventilkörper (2), der einander gegenüberliegende Seitenflächen (8) für die Aneinanderreihung gleichartiger Ventilkörper (2) zur Bildung einer Ventileinheit und an zumindest einer der gegenüberliegenden Seitenflächen (8) von außen her zugängliche Hohlräume (6) aufweist, sowie eine Ventilansteuerung (3), umfassend eine den Hohlräumen (6) zugeordnete Leiterplatte (4) mit darauf angeordneten elektronischen Bauelementen (5) zur Ansteuerung der Ventilmechanik,
**dadurch gekennzeichnet, dass** die elektronischen Bauelemente (5) bei Montage der Leiterplatte (4) auf der Seitenfläche (8) des Ventilkörpers (2) von dort ausgehend zumindest teilweise in die Hohlräume (6) hineinragen.

2. Kompaktes elektropneumatisches Mehrwegeventil nach Anspruch 1,
**dadurch gekennzeichnet, dass** die Leiterplatte (4) aus einem flexiblen, biegsamen Material besteht, so dass sich diese mit den hierauf angeordneten elektronischen Bauelementen (5) bei Montage flexibel an den Ventilkörper (2) anpasst.

3. Kompaktes elektropneumatisches Mehrwegeventil nach nach Anspruch 1 oder 2,
**dadurch gekennzeichnet,**
**dass** die Lötseite der Leiterplatte (4) von der Seitenfläche (8) des Ventilkörpers (2) weg zeigt.

4. Kompaktes elektropneumatisches Mehrwegeventil nach Anspruch 3,
**dadurch gekennzeichnet, dass** die Leiterplatte (4) mit der nach außen weisenden Lötseite einen Deckel für den Ventilkörper (2) bildet, der bündig mit dem Ventilkörper (2) abschließt.

5. Kompaktes elektropneumatisches Mehrwegeventil nach Anspruch 1,
**dadurch gekennzeichnet, dass** das Mehrwegeventil (1) eine im Wesentlichen quaderförmige äußere Gestalt aufweist.

6. Kompaktes elektropneumatisches Mehrwegeventil nach Anspruch 1,
**dadurch gekennzeichnet, dass** die Wandstärken des Ventilkörpers (2) in ihren Abmaßen derart reduziert sind, dass durch diese dünnere Ausgestaltung der Wandung in den Abmaßen maximierte Hohlräume (6) innerhalb des Ventilkörpers (2) entstehen, um größere und/oder mehrere elektronische Bauelemente (5) der Ventilansteuerung (3) in den Ventilkörper (2) zu integrieren

7. Kompaktes elektropneumatisches Mehrwegeventil nach einem der vorherigen Ansprüche,
**dadurch gekennzeichnet, dass** der Ventilkörper (2) aus Kunststoff besteht und durch Spritzgießen hergestellt ist.

8. Kompaktes elektropneumatisches Mehrwegeventil nach einem der vorherigen Ansprüche,
**dadurch gekennzeichnet, dass** die Ventilansteuerung (3) weiterhin mindestens ein Pilotventil umfasst, um die Ventilmechanik mit einem Steuerdruck zu beaufschlagen.

9. Kompaktes elektropneumatisches Mehrwegeventil nach einem der vorherigen Ansprüche,
**dadurch gekennzeichnet, dass** an den Ventilkörper (2) eine Grundplatte (7) zur Speisedruckversorgung und Entlüftung des elektropneumatischen Mehrwegeventils (1) anschließbar ist.

10. Kompakte Ventileinheit, bestehend aus einer Mehrzahl von elektropneumatischen Mehrwegeventilen (1) nach einem der Ansprüche 1 bis 10, wobei mindestens zwei elektropneumatische Mehrwegeventile (1) aneinandergereiht sind.

11. Kompakte Ventileinheit nach Anspruch 10,
**dadurch gekennzeichnet, dass** mindestens eines der aneinandergereihten Mehrwegeventile (1) eine Leiterplatte (4) aufweist, auf der die gesamte Elektronik für eine serielle Ansteuerung via Datenbus untergebracht ist.

## Claims

1. A compact electro-pneumatic multiport valve (1) for switching a pressurized medium flow, having a valve body (2) comprising a valve mechanics, the valve body (2) comprising opposite facing side surfaces (8) for the series arrangement of similar valve bodies (2) to form a valve unit and comprising cavities (6) accessible from the outside at at least one of the opposite facing side surfaces (8), and a valve drive (3) comprising a printed circuit board (4) associated with the cavities (6) having electronic components (5) arranged thereon for driving the valve mechanics,
**characterised in that**, when said printed circuit board (4) is mounted on the side surface (8) of said valve body (2), and departing from there, said electronic components (5) at least partially extend into said cavities (6).

2. The compact electro-pneumatic multiport valve according to claim 1,
**characterised in that** said printed circuit board (4) is of a resilient, flexible material, so that when it is mounted it resiliently adapts itself to the valve body (2) together with the electronic components arranged thereon.

3. The compact electro-pneumatic multiport valve according to claim 1 or 2,
**characterised in that** the solder side of the printed circuit board (3) faces away from the side surface (8) of the valve body (2).

4. The compact electro-pneumatic multiport valve according to claim 3,
**characterised in that** said printed circuit board (4), with the solder side facing the outside, forms a cover for the valve body (2) which is flush with the valve body (2).

5. The compact electro-pneumatic multiport valve according to claim 1,
**characterised in that** said multiport valve (1) has essentially a parallelepiped appearance.

6. The compact electro-pneumatic multiport valve according to claim 1,
**characterised in that** the wall thicknesses of the valve body (2) are sufficiently reduced in their dimensions to create maximized cavities (6) within the valve body (2) by this thinner configuration of the wall in order to integrate larger and/or a greater number of electronic components (5) of the valve drive (3) in the valve body (2).

7. The compact electro-pneumatic multiport valve according to any one of the preceding claims,
**characterised in that** the valve body (2) is of plastic material and made by injection moulding.

8. The compact electro-pneumatic multiport valve according to any one of the preceding claims,
**characterised in that** said valve drive (3) further comprises at least one pilot valve to apply a control pressure to the valve mechanics.

9. The compact electro-pneumatic multiport valve according to any one of the preceding claims,
**characterised in that** a base plate (7) can be coupled to the valve body (2) for feeding pressure supply and venting of the electro-pneumatic multiport valve (1).

10. A compact valve unit, consisting of a plurality of electro-pneumatic multiport valves (1) according to any one of claims 1 to 10, wherein at least two electro-pneumatic multiport valves (1) are arranged in series.

11. The compact valve unit according to claim 10,
**characterised in that** at least one of the series-arranged multiport valves (1) has a printed circuit board (3) on which the entire electronics is accommodated to be serially driven via a data bus.

## Revendications

1. Distributeur (1) électropneumatique compact à plusieurs voies, destiné à commuter un flux de fluide sous pression, comportant un corps de distributeur (2) contenant un mécanisme de distributeur et présentant des faces latérales (8) mutuellement opposées pour la mise en rangée de corps de distributeur (2) de même type en vue de constituer un ensemble distributeur, ainsi que, sur l'une au moins des faces latérales opposées (8), des cavités (6) accessibles depuis l'extérieur, et comportant un pilotage de distributeur (3) avec une carte à circuits imprimés (4) associée aux cavités (6) et comprenant des composants électroniques (5) agencés sur celle-ci et destinés à piloter le mécanisme de distributeur,
**caractérisé en ce que** lors du montage de la carte à circuits imprimés (4) sur la face latérale (8) du corps de distributeur (2), les composants électroniques (5) pénètrent à partir de celle-ci au moins partiellement dans les cavités (6).

2. Distributeur électropneumatique compact à plusieurs voies selon la revendication 1,
**caractérisé en ce que** la carte à circuits imprimés (4) est constituée d'un matériau flexible souple, de sorte que lors du montage celle-ci s'adapte de façon flexible au corps de distributeur, conjointement avec les composants électroniques (5) agencés sur celle-ci.

3. Distributeur électropneumatique compact à plusieurs voies selon l'une ou l'autre des revendications 1 et 2,
**caractérisé en ce que** le côté brasage de la carte à circuits imprimés (4) est dirigé en éloignement de la face latérale (8) du corps de distributeur (2).

4. Distributeur électropneumatique compact à plusieurs voies selon la revendication 3,
**caractérisé en ce que** la carte à circuits imprimés (4) forme, avec le côté brasage dirigé vers l'extérieur, un couvercle pour le corps de distributeur (2) qui se termine en affleurement avec le corps de distributeur (2).

5. Distributeur électropneumatique compact à plusieurs voies selon la revendication 1,
**caractérisé en ce que** le distributeur (1) à plusieurs voies présente une configuration extérieure sensiblement parallélépipédique.

6. Distributeur électropneumatique compact à plusieurs voies selon la revendication 1,
**caractérisé en ce que** les épaisseurs de paroi du corps de distributeur (2) sont de dimensions réduites de telle sorte que grâce à cette réalisation plus mince de la paroi, il résulte des cavités (6) de dimensions maximisées à l'intérieur du corps de distributeur (2), afin d'intégrer dans le corps de distributeur (2) des composants électroniques (5) plus grands et/ou en nombre plus élevé du pilotage de distributeur (3).

7. Distributeur électropneumatique compact à plusieurs voies selon l'une des revendications précédentes,
**caractérisé en ce que** le corps de distributeur (2) est constitué en matière plastique et est réalisé par coulée par injection.

8. Distributeur électropneumatique compact à plusieurs voies selon l'une des revendications précédentes,
**caractérisé en ce que** le pilotage de distributeur (3) comprend en outre au moins une valve pilote pour solliciter le mécanisme de distributeur par une pression de commande.

9. Distributeur électropneumatique compact à plusieurs voies selon l'une des revendications précédentes,
**caractérisé en ce qu'**une plaque de base (7) destinée à l'alimentation en pression et à la mise à l'air du distributeur électropneumatique (1) est susceptible d'être raccordée au corps de distributeur (2).

10. Ensemble compact de distributeurs, constitué par une pluralité de distributeurs électropneumatiques (1) à plusieurs voies selon l'une des revendications 1 à 10, dans lequel au moins deux distributeurs électropneumatiques (1) sont mis en rangée.

11. Ensemble compact de distributeurs selon la revendication 10,
**caractérisé en ce que** l'un au moins des distributeurs (1) mis en rangée comprend une carte à circuits imprimés (4) sur laquelle est logée la totalité de l'électronique pour un pilotage en série via un bus de données.
